Europäisches Patentamt

European Patent Office

Office européen des brevets

(11) Numéro de publication: **0 230 828**
**B1**

# FASCICULE DE BREVET EUROPEEN

(45) Date de publication du fascicule du brevet:
28.03.90

(51) Int. Cl.⁴: **H03K 4/50**, H04N 5/12

(21) Numéro de dépôt: **86402864.2**

(22) Date de dépôt: **19.12.86**

(54) Procédé et circuits de fourniture d'un signal de balayage vertical pour un téléviseur associé à un magnétoscope.

(30) Priorité: **24.12.85 FR 8519125**

(43) Date de publication de la demande:
**05.08.87 Bulletin 87/32**

(45) Mention de la délivrance du brevet:
**28.03.90 Bulletin 90/13**

(84) Etats contractants désignés:
**DE FR GB IT NL**

(56) Documents cités:
**EP-A- 227 551**
**EP-A- 0 099 611**
**US-A- 4 387 397**

**ELECTRONIQUE APPLICATIONS,**
**no. 32, octobre-novembre 1983, pages 41-49, Evry, FR;**
**J. REBERGA: "Balayage horizontal et vertical en circuit intégré"**

(73) Titulaire: **THOMSON-CSF, 51, Esplanade du Général de Gaulle, F-92800 Puteaux(FR)**

(72) Inventeur: **Merval, Jean-Marc, THOMSON-CSF SCPI 19, avenue de Messine, F-75008 Paris(FR)**

(74) Mandataire: **de Beaumont, Michel, 1bis, rue Champollion, F-38000 Grenoble(FR)**

ACTORUM AG

## Description

La présente invention concerne des procédés et circuits de fourniture d'un signal de balayage vertical.

Plus particulièrement, la présente invention concerne de tels procédés et circuits de fourniture d'un circuit de balayage vertical qui soient optimisés dans le cas d'un téléviseur fonctionnant sur magnétoscope, ces circuits étant conçus pour être simplement combinés en un circuit d'ensemble simple permettant d'assurer également de façon optimale le fonctionnement du téléviseur dans le cas d'une réception directe.

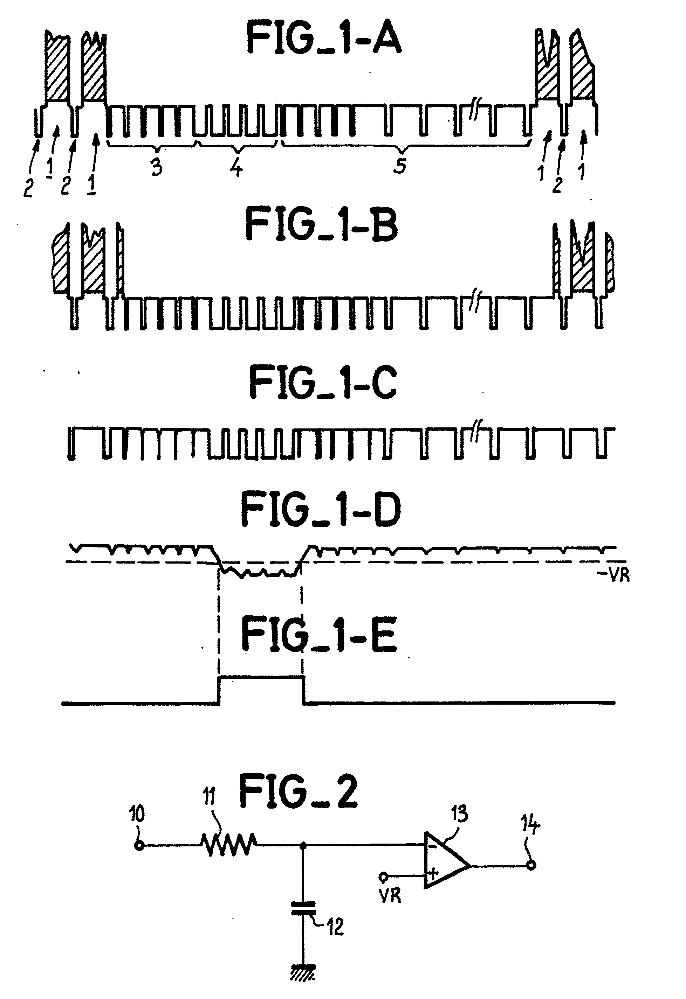

De façon générale, et en négligeant les fréquences porteuses, un téléviseur reçoit un signal vidéo composite tel que représenté en figures 1A et 1B. L'image est transmise en deux trames entrelacées.

Comme le représente la figure 1A, la fin d'un signal de trame, comprenant des signaux vidéo composites 1 correspondant à une ligne de balayage séparés par des impulsions de synchronisation de ligne 2, est suivie d'une zone où seuls des signaux de synchronisation sont émis. Ces signaux de synchronisation comprennent des signaux dits de présynchronisation de trame 3, des signaux de synchronisation de trame 4 et des signaux dits de postsynchronisation de trame 5, après quoi les signaux 1 séparés par les impulsions de synchronisation de ligne 2 (ou synchronisation horizontale) reprennent.

La figure 1B représente les signaux de synchronisation de trame après la fin d'une trame impaire, si la figure 1A représentait la fin d'une trame paire. On notera que les signaux de synchronisation horizontale sont déphasés de la moitié de la période de balayage horizontal.

De façon classique, on cherche à extraire les signaux de synchronisation de ligne et de trame. Dans un premier temps, on extrait ce qui est appelé un signal de synchronisation de ligne composite tel que représenté en figure 1C, résultant des signaux des figures 1A ou 1B écrêtage. Ensuite, une intégration à constante de temps longue devant la durée des signaux de synchronisation horizontale fournit un signal de synchronisation de trame représenté en figure 1D qui est mis en forme de la façon représentée en figure 1E, par exemple par comparaison avec une tension de seuil -VR indiquée en figure 1D.

Un circuit classique élémentaire pour extraire le signal de synchronisation de trame du signal de synchronisation de ligne composite est illustré en figure 2. Si le signal de synchronisation de ligne composite est appliqué à l'entrée 10 de ce circuit, on obtient le signal de la figure 1D à l'aide d'un circuit intégrateur comprenant une résistance 11 et un condensateur 12. Ce signal est appliqué à un comparateur 13 dont l'autre entrée reçoit une tension de référence VR et le signal de la figure 1E, le signal de synchronisation de trame, est obtenu à la sortie 14 du comparateur 13.

Un tel circuit a été présenté uniquement à titre d'exemple, pour faire comprendre les problèmes que visera à résoudre la présente invention mais il est clair qu'il n'est pas adapté à une réalisation sous forme de circuit intégré car il nécessite la présence d'un condensateur 12 de forte valeur.

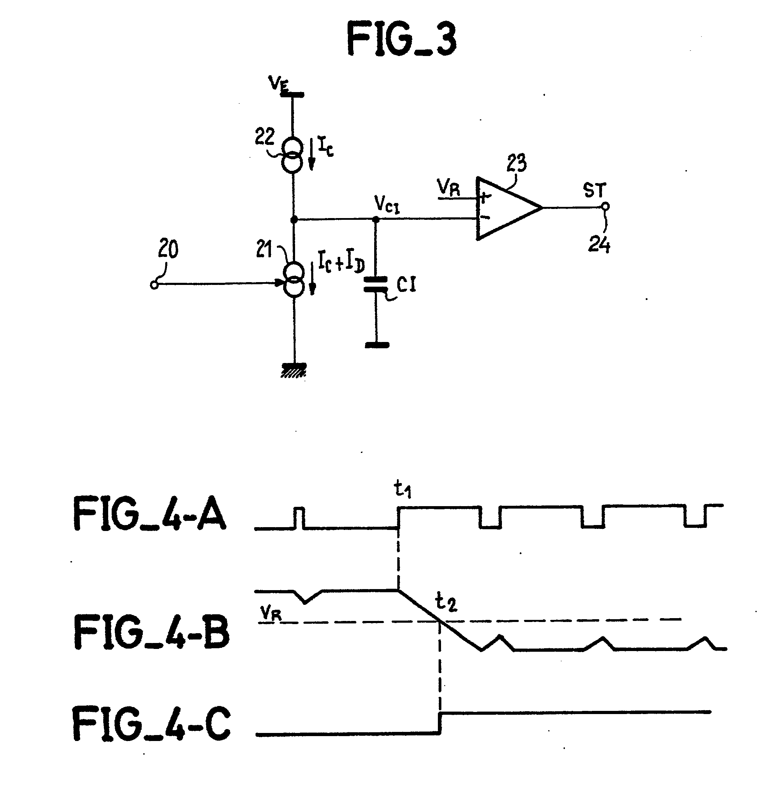

Pour la réalisation d'un circuit d'extraction de signal de synchronisation de trame en circuit intégré, on choisit plutôt un circuit du type de celui de la figure 3. Le signal de synchronisation de ligne composite appliqié à l'entrée 20 de ce circuit commande la conduction ou la non-conduction d'une source de courant 21. La source de courant 21 est connectée d'une part à la masse, d'autre part à une tension d'alimentation VE par l'intermédiaire d'une source de courant 22 dirigée dans le même sens que la source de courant 21. Le point de raccordement des sources de courant 21 et 22 est connecté, d'une part, à une première entrée d'un comparateur 23 dont la deuxième entrée reçoit une tension de référence VR et, d'autre part, à une borne d'un condensateur de faible valeur C1 dont l'autre borne est connectée à la masse.

Le fonctionnement du circuit de la figure 3 est le suivant. Quand l'entrée 20 inhibe la source de courant 21, la source de courant 22 charge le condensateur C1 par un courant IC jusqu'à ce que la tension à ses bornes VC1, atteigne la tension VE. Quand l'entrée 20 valide la source de courant 21, celle-ci entraîne le passage d'un courant IC + ID, c'est-à-dire que le condensateur C1 se décharge à courant ID jusqu'à ce que VC1 atteigne le potentiel de la masse ou que la source de courant 21 soit à nouveau inhibée. Le signal à la sortie 24 du comparateur 23 est le signal de synchronisation de trame ST.

Les figures 4A à 4C illustrent les formes des signaux apparaissant en différents points du circuit de la figure 3. La figure 4A représente le signal de synchronisation de ligne composite à la borne 20. Pendant toute la durée de l'image et la durée des signaux de présynchronisation trame, le signal 20 est de façon générale à bas niveau sauf pendant de brefs instants au moment des tops de synchronisation ligne. Par contre, à partir de l'instant t1 de début de la période de synchronisation de trame, les périodes à haut niveau sont longues devant les périodes à bas niveau.

La figure 4B représente la tension VC1 aux bornes du condensateur C1 . On peut voir qu'avant l'instant t1, pendant les tops de synchronisation ligne, le condensateur C1 n'a pas le temps de se décharger au point que la tension VC1 atteigne la tension de référence VR. C'est seulement à partir de l'instant t1 que cette tension VC1 décroît suffisamment, pour atteindre la tension de référence VR à l'instant t2.

La figure 4C représente le signal à la sortie du comparateur 23. Ce signal de synchronisation de trame ST change d'état à l'instant t2.

De façon classique, c'est ce changement d'état que l'on utilise directement comme signal de synchronisation trame pour commander à cet instant t2 l'inversion de sens de la dent de scie de balayage vertical appliquée aux bobines de déviation verticale du téléviseur.

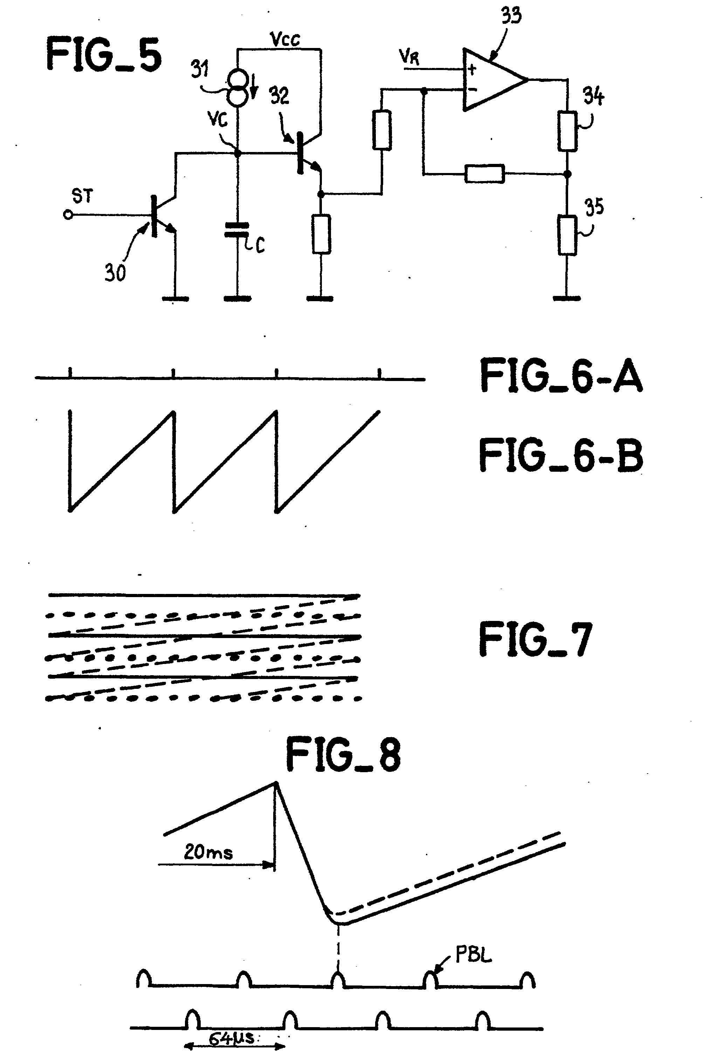

La figures 5 représente un circuit classique de commande de déviateur vertical. Le signal de synchronisation de trame ST est appliqué à l'entrée d'un générateur de dents de scie, plus particulièrement à la base d'un transistor 30 dont l'émetteur est relié à la masse et le collecteur à une première borne d'un condensateur C dont l'autre borne est reliée à la masse. Ce condensateur se charge sous l'effet d'une source de courant 31 et sa tension est transmise, par un transistor 32 monté en émetteur-suiveur, à un amplificateur de puissance 33. La sortie de cet amplificateur de puissance 33 alimente une bobine de déviation verticale 34, généralement en série avec une résistance de mesure de courant 35.

La figure 6A représente à une échelle plus petite que celle des figures précédentes des signaux de synchronisation de trame successifs. La figure 6B représente la tension VC aux bornes du condensateur C, qui est appliquée par l'intermédiaire du circuit amplificateur à la bobine de déviation. En l'absence du signal ST, le condensateur C se charge et la tension VC croît progressivement pour chuter brutalement dès que le signal ST est appliqué à la base du transistor 30 et recommencer à croître quand le signal ST est interrompu.

La figure 7 représente des lignes de balayage successives sur un téléviseur. Les lignes en traits pleins indiquent le balayage des trames impaires et les lignes en traits pointillés gras indiquent le balayage des lignes des trames paires. En pointillés légers sont indiquées les traces de retour ligne. Il est important que les lignes d'une trame paire soient exactement centrées entre les lignes d'une trame impaire. Un effet optique déplaisant apparaît pour le téléspectateur dès qu'un décentrage de l'ordre de 10 % se produit. Normalement, les signaux de synchronisation trame de deux trames successives sont décalés de façon à ce que les dents de scie successives des trames paire et impaire soient elles-même convenablement décalées.

On notera, toutefois, qu'un décalage de 10 % doit correspondre à un réglage très précis du point de démarrage de la montée de la dent de scie de balayage vertical. En effet, si la dent de scie a une amplitude de 2 V, la précision que l'on doit atteindre est de $2/10 \times 625 = 3{,}2 \ 10^{-4}$ V ou 0,3 mV. On conçoit qu'une telle précision soit difficile à atteindre notamment si l'on tient compte de ce que les divers composants des circuits déterminant les constantes de temps de la dent de scie et son amplitude peuvent varier en fonction de la température, du vieillissement et de leur valeur initiale d'un téléviseur à un autre.

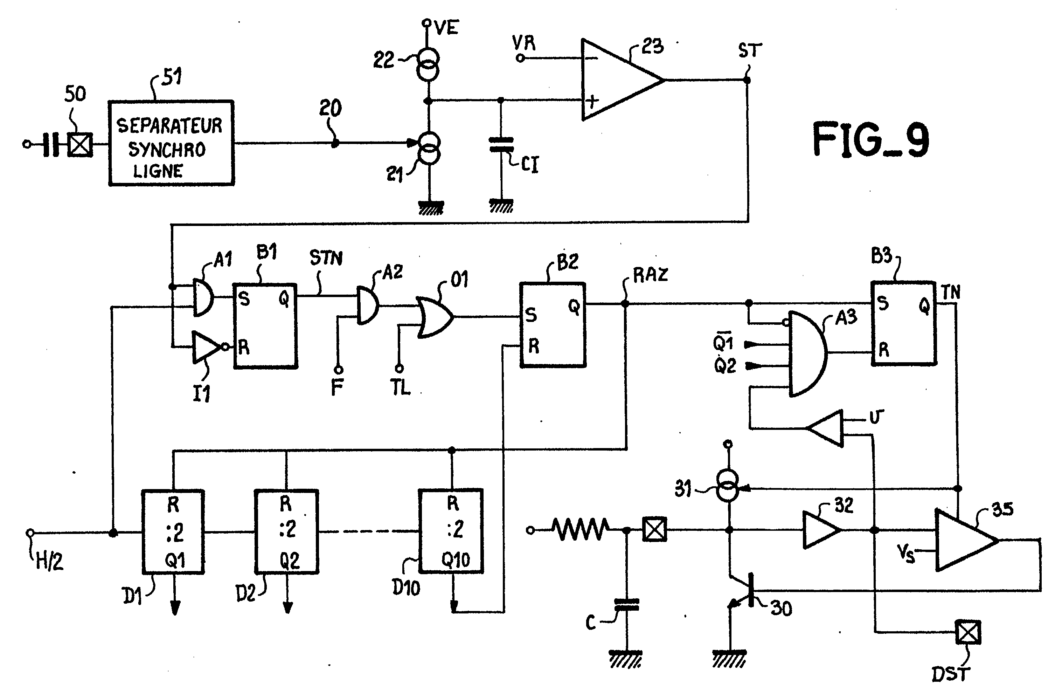

En outre, le balayage horizontal du téléviseur (balayage ligne) nécessite des courants de valeur importante avec des variations de courant élevées pendant les retours lignes. Ces impulsions de retour ligne produisent une pollution importante des circuits de masse pendant la durée du retour ligne (courant de masse, rayonnement électromagnétique). Comme le montre la figure 8, si une impulsion résultant d'un parasite de balayage ligne PBL se produit au moment où la dent de scie de balayage trame commence à remonter, au lieu d'avoir la dent de scie prévue indiquée en trait plein dans la courbe supérieure de la figure 8, on obtient l'allure représentée en pointillés, c'est-à-dire un décalage de toutes les lignes de cette trame. Dans ce cas, la trame suivante ne sera pas affectée du même décalage car le début de charge aura lieu entre deux parasites. Il en résulte trame à trame un décalage du niveau de la dent de scie et donc l'apparition d'un défaut visible pour le téléspectateur.

Un objet de la présente invention est de prévoir un procédé et des circuits de fourniture de signal de commande de dent de scie de balayage de trame permettant d'éviter ces inconvénients en fonctionnement en mode de réception normal.

Un objet de la présente invention est de permettre d'obtenir une bonne stabilité de synchronisation trame lorsque le téléviseur est utilisé également avec un magnétoscope.

Un objet de la présente invention est de prévoir des procédés et circuits permettant d'atteindre ce résultat de façon optimale dans le cas d'une réception directe et dans le cas d'un couplage avec un magnétoscope, ces deux circuits étant chacun optimaux pour leur application et pouvant être combinés en un circuit intégré unique utilisant des composants élémentaires communs pour ces deux circuits.

Pour atteindre ces objets ainsi que d'autres, la présente invention prévoit un procédé de fourniture du signal en dent de scie de balayage vertical d'un téléviseur couplé à un magnétoscope à partir du signal de synchronisation trame (ST) fourni par un intégrateur, comprenant les étapes suivantes :
- interrompre l'action du générateur de dent de scie de trame à partir de l'apparition du signal de synchronisation de trame ST,
- à partir de cet instant, ou après un retard prédéterminé à partir de cet instant, mesurer une durée déterminée en utilisant le temps de charge jusqu'à un niveau déterminé du condensateur dudit intégrateur, et
- réinitialiser le fonctionnement du générateur de dent de scie de trame à partir de la fin de cette durée déterminée.

Dans ce procédé, l'étape d'interruption comprend les étapes consistant à faire chuter le signal du générateur de dent de scie à bas niveau et à le maintenir à bas niveau.

La présente invention prévoit également un circuit de fourniture d'un signal en dent de scie de balayage vertical d'un téléviseur associé à un magnétoscope comprenant un intégrateur de signal de synchronisation ligne composite fournissant le signal de synchronisation trame (ST) ; cet intégrateur comprend deux sources de courant en série, le point de connexion de ces deux sources de courant étant connecté à un condensateur (CI) dont l'autre borne est à la masse, la tension sur le condensateur (CI) étant appliquée à une première entrée d'un comparateur dont l'autre entrée reçoit une tension de référence (VR), la sortie de ce comparateur fournissant le signal de synchronisation trame (ST) ; ce circuit comprend en outre un interrupteur commandé connecté aux bornes du condensateur (CI) pour permettre la mise en court-circuit de celui-ci dans un intervalle de temps qui suit l'instant où le comparateur commence à fournir un signal (ST).

Dans un mode de réalisation, le signal (ST) est appliqué à une deuxième bascule qui fournit un signal de courte durée (RAZ) qui est appliqué à l'entrée d'une troisième bascule, fournissant le signal de commande de dent de scie verticale, pour la mettre à haut niveau ; la deuxième entrée de la troisième bascule reçoit le signal (ST) inversé, pour être remise à zéro seulement quand le signal (ST) repasse à bas niveau, c'est-à-dire quand le condensateur (CI) s'est rechargé à une tension égale à la tension de référence (VR).

Dans une mode de réalisation, le circuit de génération de dent de scie recevant le signal de sortie de la troisième bascule comprend un condensateur (C) en série avec une source de courant et en parallèle avec un transistor de court-circuit, la borne commune à la source de courant et au condensateur (C) étant reliée par l'intermédiaire d'un circuit adaptateur à un comparateur effectuant une comparaison avec une tension de seuil ; le signal de sortie de la troisième bascule est appliqué à la source de courant et au comparateur du circuit de génération de dent de scie pour les inhiber quand ce signal est à haut niveau.

L'invention prévoit en outre un circuit mixte permettant de commander les dents de scie de balayage vertical d'un téléviseur dans le cas où celui-ci reçoit directement des signaux d'antenne, pour fournir dans ce cas un signal de commande associé à l'apparition successive de tops de synchronisation ligne et de largeur égale à l'intervalle entre ces tops de synchronisation, ce circuit comprenant des moyens pour appliquer un signal de sélection de mode à l'état 0 ou 1 selon qu'on est en mode direct ou en mode magnétoscope ; ce circuit mixte comprend un ensemble de trois bascules dont la première fournit un signal pendant la présence du signal de synchronisation de trame (ST) à partir de la première apparition d'un top de synchronisation à la fréquence double de la fréquence ligne (H/2), cette première bascule étant inhibé dans le mode magnétoscope, auquel cas le signal de synchronisation de trame est directement appliqué par un commutateur logique à l'entrée d'un circuit de validation connecté à la deuxième bascule.

Dans un mode de réalisation du circuit mixte, la sortie (STN) de la première bascule est appliquée à l'entrée de la seconde bascule par l'intermédiaire d'une porte ET recevant aussi un signal de fenêtre (F) pour permettre l'application d'un signal sur la deuxième bascule seulement pendant la durée où il est possible qu'apparaisse normalement un signal (ST).

Dans un mode de réalisation du circuit mixte, la sortie (STN) de la première bascule est transmise à l'entrée de la deuxième bascule par l'intermédiaire d'une porte OU recevant sur sa deuxième entrée un signal (TL) fourni par des circuits logiques du téléviseur à partir du signal à fréquence double (H/2) pour déclencher la deuxième bascule peu après l'instant probable d'apparition du signal de synchronisation de trame (ST) au cas où ce signal n'aurait pas été fourni.

Dans un mode de réalisation du circuit mixte, la sortie (RAZ) de la seconde bascule est appliquée aux entrées de remise à zéro d'un ensemble de diviseurs par deux connectés séquentiellement et recevant à leur entrée le signal (H/2) pour fournir une succession de signaux logiques qui, combinés de diverses manières, peuvent assurer diverses fonctions de synchronisation pour les circuits du téléviseur.

Ces objets, caractéristiques et avantages ainsi que d'autres de la présente invention seront exposés plus en détail dans la description suivante de modes de réalisation particuliers faite en relation avec les figures jointes parmi lesquelles:

les figures 1 à 8 destinées à exposer le domaine de la présente invention et l'état de la technique ont été décrites précédemment;

la figure 9 représente de façon schématique un mode de réalisation d'un circuit pour la réception directe de signaux de télévision;

la figure 10 représente des signaux apparaissant en divers points du circuit de la figure 9;

(les figures 1 à 10 apparaissent également dans le document EP-A 0227 551 de la demanderesse ayant la même date de priorité),

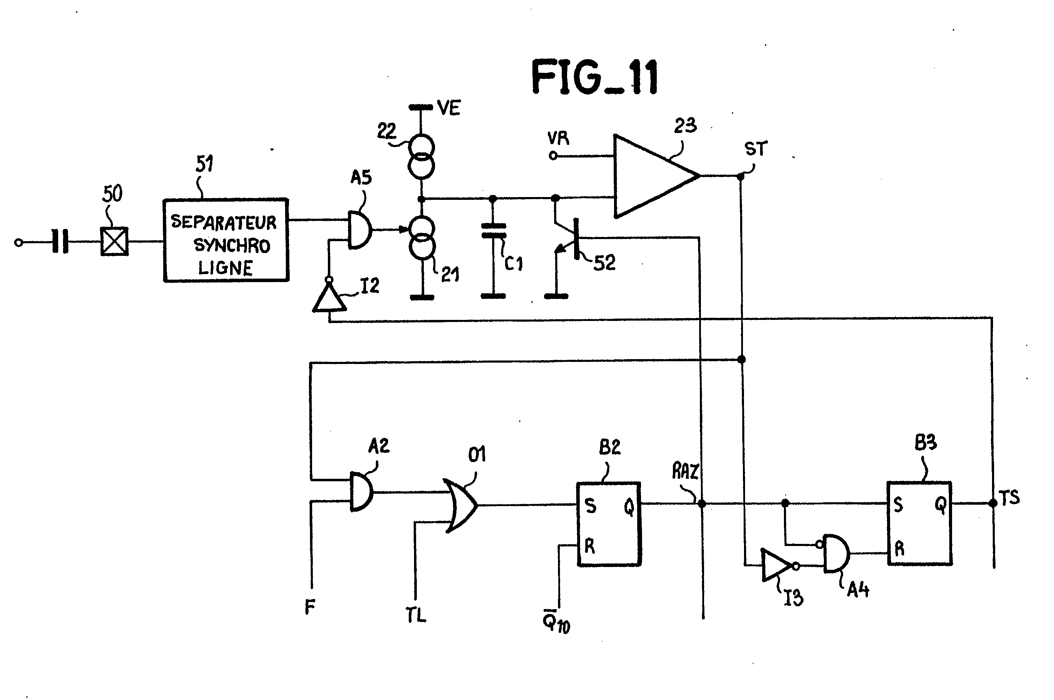

la figure 11 représente de façon schématique un mode de réalisation d'un circuit selon la présente invention pour la réception de signaux en mode magnétoscope;

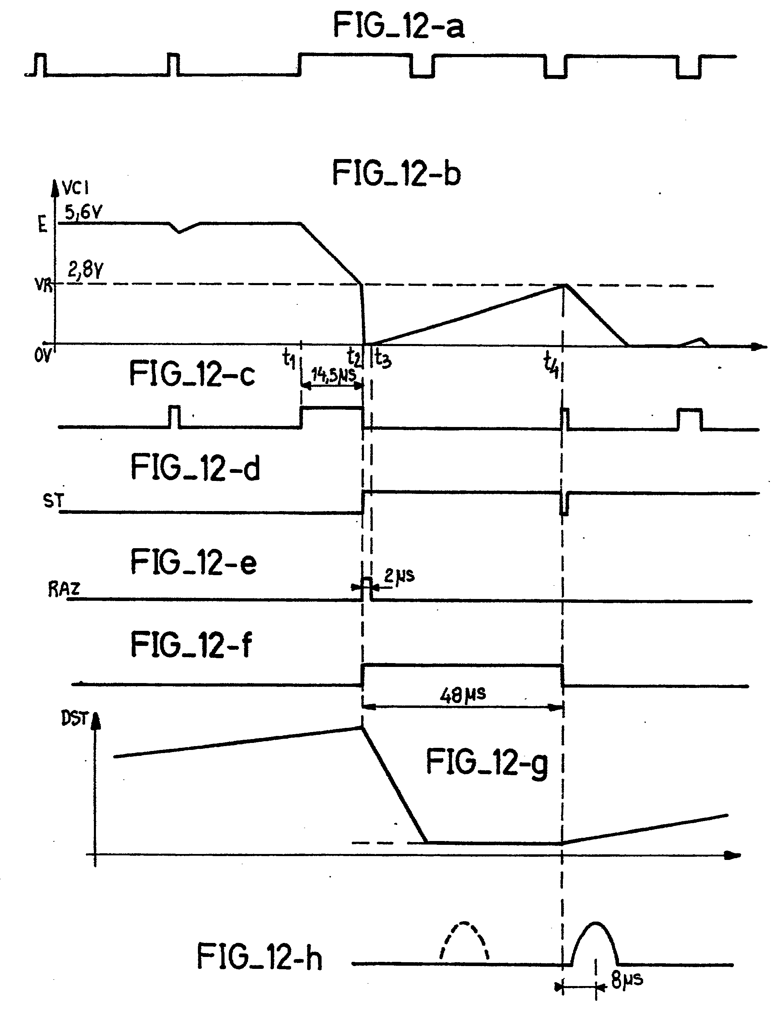

la figure 12 représente des signaux apparaissant en divers points du circuit de la figure 11 ; et

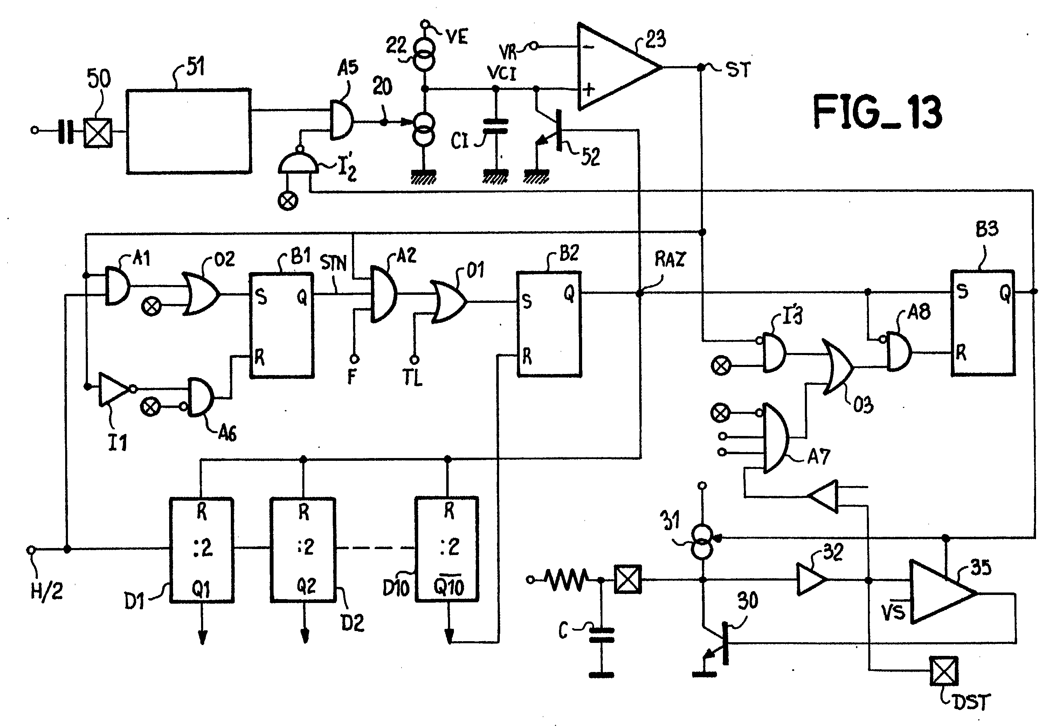

la figure 13 représente un circuit selon la présente invention combinant les modes de réalisation des figures 9 et 11.

Le circuit de la figure 9 reçoit à sa borne d'entrée 50, le signal vidéo composite par l'intermédiaire d'un condensateur de couplage. Un circuit 51 agit comme séparateur de synchronisation ligne pour fournir le signal de synchronisation ligne composite appliqué à un circuit du type déjà décrit en relation avec la figure 3 et dans lequel de mêmes éléments sont indiqués par de mêmes références : entrée 20, sources de courant 21 et 22, condensateur C1 , et comparateur 23 fournissant à sa sortie un signal de synchronisation trame ST.

Le signal ST est fourni à l'entrée S d'une bascule B1 par l'intermédiaire d'une porte ET A1 dont l'autre entrée reçoit un signal H/2 à fréquence double des tops de synchronisation ligne et en relation de phase avec les impulsions de retour ligne. Le signal ST est également appliqué à l'entrée R de la bascule B1 par l'intermédiaire d'un inverseur I1.

La sortie Q de la bascule B1 est transmise à l'entrée S d'une bascule B2 par l'intermédiaire d'une porte ET A2 et d'une porte OU 01. L'autre entrée de la port ET A2 reçoit un signal de fenêtre F et l'autre entrée de la porte OU 01 reçoit un signal TL (top de fréquence libre).

Les signaux F et TL sont fournis à partir d'une succession de diviseurs par deux D1 à D10 recevant les signaux H/2 précédemment mentionnés. Le signal de fenêtre F correspond à une période pendant laquelle le signal de synchronisation trame est susceptible de se produire pour éviter que la porte ET A2 ne transmette un signal qui se produirait en dehors de la période de synchronisation de trame. Le signal TL est un top fourni par comptage des impulsions de synchronisation ligne successives pour faire fonctionner le circuit et déclencher le balayage de trame dans le cas où, dans le signal émis, ce signal de synchronisation de trame serait noyé dans du bruit ou brouillé pour diverses raisons. La sortie du dernier diviseur Q10, ou plutôt son inverse Q10, est appliquée comme signal de remise à zéro à l'entrée R de la bascule B2.

La sortie Q de la bascule B2 (signal RAZ) est appliquée à l'entrée S d'une bascule B3 dont l'entrée R reçoit cette même sortie Q de la bascule B2 inversée et transmise par l'intermédiaire d'une porte ET A3 dont les autres entrées reçoivent divers signaux de validation tels que des signaux Q1 et Q2 en provenance des diviseurs D1 et D2. La sortie Q de la bascule B3 est un signal TN (commande du générateur de dent de scie trame) qui servira à commander la dent de scie de balayage vertical.

Dans le circuit de fourniture de dent de scie de balayage vertical, on retrouve des composants déjà décrits en figure 5 et ayant les mêmes fonctions, à savoir un transistor 30 pour court-circuiter temporairement le condensateur C chargé par une source de courant 31, la tension VC aux bornes du condensateur C étant transmise par un circuit adaptateur ou transistor en émetteur-suiveur 32 à un comparateur 35. Ce comparateur 35 est muni d'une entrée de validation qui reçoit le signal TN. C'est la sortie de ce comparateur qui commande le transistor 30, c'est-à-dire la mise en court-circuit et la décharge du condensateur C. On notera que le signal TN est également appliqué à la source de courant 31 pour l'inhiber quand il est à haut niveau. C'est le signal de sortie de l'émetteur-suiveur 32 qui constitue la borne d'alimentation de la bobine de déviation. La sortie de cet émetteur-suiveur 32 est également appliquée, par l'intermédiaire d'un comparateur à une tension de seuil v, à une quatrième entrée de la porte ET A3.

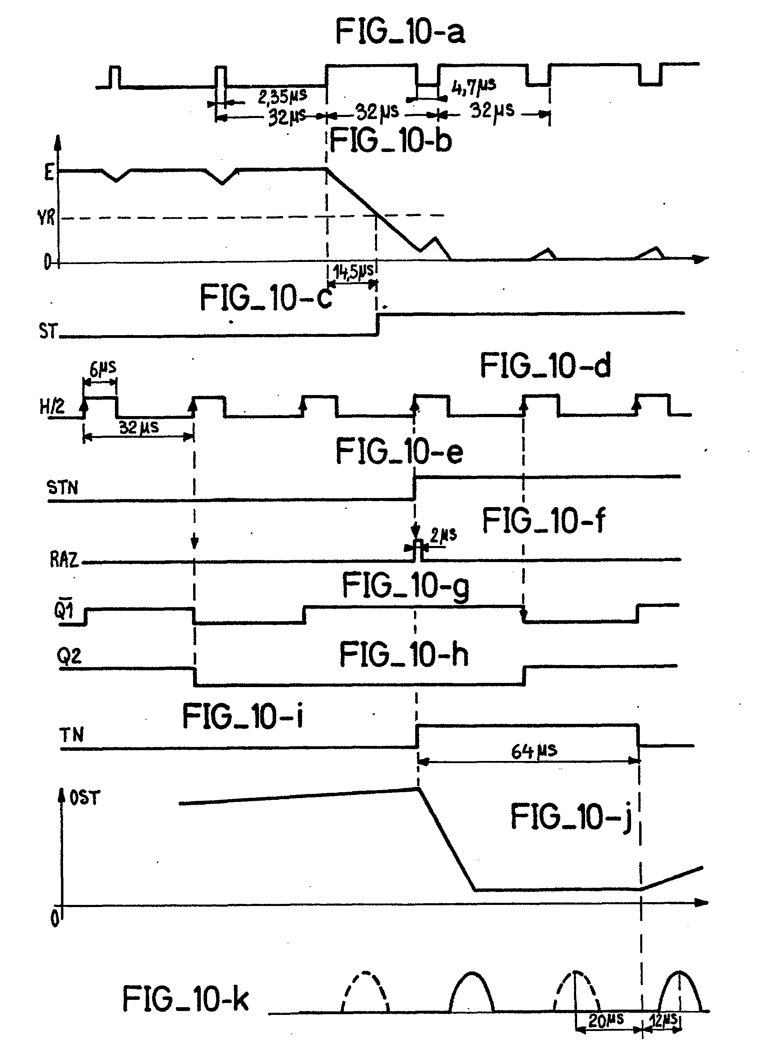

Le fonctionnement du circuit de la figure 9 va maintenant être exposé en relation avec les diagrammes de temps de la figure 10.

En figure 10, la courbe 10a représente le signal de synchronisation de ligne composite présent au point 20 du circuit. La courbe 10a indique de façon détaillée les durées des diverses phases de ce signal. On se référera à la figure pour lire ces valeurs.

La courbe 10b indique l'allure de la tension VC1 aux bornes du condensateur C1 ainsi que la tension VR présente à la deuxième entrée du comparateur 23. Comme on peut le voir, la durée normale, dans l'exemple représenté, du retard entre le début de la première impulsion de synchronisation de trame et l'instant où VC1 devient égal à VR est égale à 14,5 ms. Toutefois, cette durée peut varier et c'est en particulier de ces fluctuations que l'on veut s'affranchir.

La figure 10c représente le signal ST présent à la sortie du comparateur 23 qui passe à niveau haut quand la tension VC1 devient égale à la tension VR.

La figure 10d représente le signal H/2 appliqué à la deuxième entrée de la porte ET A1 dont la première entrée reçoit le signal ST. Ce signal H/2 est généré à partir des tops de synchronisation de ligne et sert également par ailleurs à déterminer les signaux de balayage ligne. Il y a donc une relation de phase déterminée entre les signaux H/2 et les périodes de retour ligne qui provoquent, comme on l'a indiqué précédemment, des perturbations dans l'ensemble du circuit représentées sur la figure 10k pendant les durées de retour ligne.

Ainsi, la porte ET A1 fournit un signal à haut niveau dès l'apparition du front de montée de la première impulsion H/2 qui suit le passage à haut niveau du signal ST. Il en résulte, comme le montre la figure 10e, à la sortie de la bascule B1 un signal STN de synchronisation de trame numérique qui passe à haut niveau avec ce front de montée de l'impulsion H/2. La bascule B2, comme le montre la figure 10f, fournit une impulsion brève RAZ et sert à remettre à zéro tous les diviseurs D1 à D10 et à commander l'entrée S de la bascule B3. Le signal RAZ a, par exemple, une durée de 2 microsecondes.

La courbe 10g représente la sortie Q1 du diviseur D1 qui passe immédiatement à haut niveau après l'application de signal de remise à zéro puisque l'on se trouve pendant un niveau haut du signal H/2.

La courbe 10h représente la sortie Q2 du diviseur D2 qui passe à haut niveau lors de l'impulsion suivante du signal H/2 (c'est-à-dire 32 microsecondes plus tard). On notera que le signal Q1 passe à nouveau à haut niveau pour l'impulsion encore suivante du signal H/2 (c'est-à-dire 64 microsecondes plus tard).

La bascule B3 fournit, elle, le signal TN que l'on cherche à obtenir et qui sera utilisé pour la commande de la dent de scie de balayage. La bascule B3, commandée par le signal RAZ de sortie de la bascule B2, passe à haut niveau en même temps que les signaux STN et RAZ. Elle est remise à zéro par les entrées présentes sur la porte ET A3 c'est-à-dire Q1 et Q2. Cette remise à zéro s'effectue donc 64 microsecondes (ou un nombre entier de fois 32 microsecondes) après la mise à 1.

La courbe 10j représente la dent de scie de trame (DST) appliquée au déviateur vertical. Cette dent de scie voit sa tension diminuer au moment du passage à haut niveau des signaux STN, RAZ et TN et décroît rapidement au rythme déterminé par la décharge du condensateur C dans le transistor 30. Cette décharge s'arrête à une certaine tension de seuil VS qui est la tension appliquée à la deuxième entrée du comparateur 35, par exemple 1,26 V. Ensuite, la source de courant 31 étant inhibée par le signal TN, le signal DST reste à zéro jusqu'à la fin de l'impulsion TN. C'est à ce moment seulement que la dent de scie commence à croître. Cette croissance a lieu, comme on l'a vu précédemment, simultanément avec un front de montée du signal H/2 qui est en relation de phase choisie avec les périodes de retour ligne pour que les retours ligne ne se produisent pas à cet instant. Il est donc certain que le départ de la dent de scie ne sera pas parasité et donc que le phénomène de décalage des lignes horizontales des trames paires et impaires ne peut se produire.

On comprendra maintenant que la quatrième entrée de la porte ET A3 est une entrée de validation qui empêche que la dent de scie commence à se recharger tant que sa décharge n'a pas été complète, c'est-à-dire qu'elle n'a pas atteint un niveau de tension v prédéterminé.

On a décrit ci-dessus un circuit numérique de commande de dent de scie de balayage trame qui fournit des résultats excellents dans le cas où les signaux d'entrée sont des signaux normaux reçus directement par un téléviseur.

Toutefois, un tel circuit qui réalise une synchronisation sur les signaux H/2 pendant la période de synchronisation trame ne peut être utilisé quand un téléviseur reçoit des signaux d'un magnétoscope. En effet, dans le cas de signaux fournis par magnétoscope, après des opérations telles qu'un arrêt sur image, un accéléré ou un retour arrière, la synchronisation trame est fortement perturbée et la périodicité peut varier d'une trame à l'autre avec des écarts possibles de plusieurs lignes. Par ailleurs, une trame sur deux, la synchronisation trame est régénérée par un système électronique donc, une trame sur deux, il n'y a pas de relation de phase précise entre la synchronisation horizontale ou synchro ligne et la synchronisation verticale ou synchro trame. En conséquence, pour une bonne stabilité de l'image, il n'est pas possible en mode magnétoscope que la synchronisation de trame soit en relation de phase avec la synchronisation de ligne.

En conséquence, la présente invention prévoit un circuit de synchronisation en mode magnétoscope qui permette par rapport aux circuits de l'art antérieur de fournir une synchronisation généralement satisfaisante et qui en outre soit compatible dans sa réalisation avec le circuit de synchronisation numérique décrit précédemment pour pouvoir être regroupé avec celui-ci dans un circuit dont de nombreux éléments sont communs et dont certains sont différemment commutés selon le mode de réception d'images.

La figure 11 représente un mode de réalisation de l'invention adapté à une réception de signaux de télévision en provenance d'un magnétoscope. On retrouve dans ce circuit une entrée 50 et un séparateur de synchronisation de ligne 51. Le signal de synchronisation de ligne composite à la sortie du circuit 51 commande la source de courant 21 par l'intermédiaire d'une porte ET A5. Par ailleurs, on retrouve la source de courant 22, le condensateur C1 et le comparateur 23. La sortie ST du comparateur 23 est cette fois appliquée directement à l'entrée d'une porte ET A2 dont l'autre entrée reçoit le signal de fenêtre F puis à une entrée d'une porte OU 01 dont l'autre entrée reçoit les tops de synchronisation libres TL et dont la sortie est connectée à l'entrée S d'une bascule B2 fournissant le signal de sortie RAZ. L'entrée R de la bascule B2 reçoit le signal Q10 inverse du signal Q10. La sortie Q de la bascule B2 est connectée à l'entrée S de la bascule B3 qui fournit en sortie un signal TS de commande du circuit de balayage de trame vers les entrées d'inhibition de la source de courant 31 et du comparateur 35 (non représentés en figure 11). L'entrée R de la bascule B3 reçoit la sortie d'une porte ET A4 dont la première entrée reçoit le signal RAZ inversé et dont la deuxième entrée reçoit le signal ST inversé par un inverseur I3. Le signal TS est aussi utilisé comme deuxième entrée pour la porte ET A5, par l'intermédiaire d'un inverseur I2.

Ce circuit comprend en outre un transistor 52 en parallèle avec le condensateur C1 et dont la base reçoit le signal RAZ de sortie de la bascule B2.

Le fonctionnement de ce circuit va être expliqué en relation avec les diagrammes de la figure 12.

La figure 12a représente comme la figure 10a le signal de synchronisation de ligne composite.

La figure 12b représente l'allure de la tension VC1 aux bornes du condensateur C1.

A l'instant t1 où apparaît le premier top de synchronisation de trame, la tension VC1 commence à chuter à un rythme imposé par la différence de courant ID entre les sources de courant 21 et 22. A l'instant t2, la tension VC1 atteint la tension de référence VR, par exemple 2,5 V, la tension VE étant égale à 5,6 V.

La figure 12d indique l'allure du signal ST à la sortie du comparateur 23. Ce signal passe à haut niveau à l'instant t2. L'impulsion RAZ est alors fournie par la bascule B2 et le signal de sortie de la bascule B3, TS, passe à haut niveau commandant la décharge du générateur de dents de scie de trame de la façon décrite précédemment. Simultanément, l'apparition du signal TS inhibe la porte ET A5 entre les éléments 51 et 21. La source de courant 21 est donc inhibée et le condensateur C1 recommence à se charger au rythme défini par la source de courant 22, alors que ce condensateur C1 était court-circuité par le transistor 52 pendant la durée de l'impulsion RAZ. La charge commence donc donc seulement à un instant t3 à la fin de l'impulsion RAZ. Quand la tension sur le condensateur C1 atteint à nouveau la valeur VR, à l'instant t4, le signal de synchronisation de trame ST est interrompu et par suite, par le jeu des bascules B2 et B3, le signal TS est interrompu. On notera que la différence entre les instants t2 et t4 peut être déterminée avec précision en fonction de la durée de charge du condensateur C1. On choisira par exemple cette valeur de l'ordre de 48 microsecondes, ce qui correspond à une valeur suffisante pour que dans tous les cas la dent de scie de trame descende complètement à son niveau de seuil et qui représente statistiquement un instant auquel en raison des diverses synchronisations de balayage ligne, en relation avec le début de balayage trame, une impulsion de retour ligne est peu susceptible de se produire. A cet instant t4, le générateur de dent de scie recommence à fournir une dent de scie croissante.

On notera que c'est l'une des orginalités du circuit décrit précédemment que d'utiliser le condensateur C1 du séparateur de synchronisation de trame pour deux fonctions :
- la fonction classique d'intégrateur pour la séparation du signal de synchronisation de trame,
- une fonction de monostable de durée déterminée pour servir de base de temps pour la détermination d'une impulsion de commande TS de largeur constante déterminée.

Ainsi, dans ce fonctionnement en mode magnétoscope, le front montant de l'impulsion TS de commande de la dent de scie est déclenché par l'impulsion de synchronisation de trame ST alors que le front descendant est déterminé par le temps de charge du condensateur C1.

Comme cela a été souligné précédemment, le circuit de fourniture d'un signal de commande de dent de scie selon la présente invention en mode magnétoscope est particulièrement apte à être regroupé de façon simple avec le circuit décrit ci-dessus fonctionnant en mode de réception directe par antenne. Ce regroupement est indiqué en figure 13.

Dans le circuit de la figure 13, des composants identiques ou analogues à ceux des figures 9 et 11 sont désignés par des références identiques.

Le circuit de la figure 13 comprend tous les éléments du circuit de la figure 9, les quelques éléments supplémentaires de la figure 11, et en outre certains ensembles de validation destinés à assurer la commutation de fonctionnement du circuit dans le mode direct ou dans le mode magnétoscope.

On va décrire ici seulement ces circuits de validation supplémentaires. Ils comprennent une porte OU 02 dont une entrée reçoit la sortie de la porte ET A1, dont la sortie est connectée à l'entrée S de la bascule B1 et dont l'autre entrée reçoit le signal de sélection de mode. Dans la figure 13, l'entrée de sélection de mode est indiquée par une croix inscrite dans un cercle. Ce signal de sélection de mode est à 0 dans le mode direct et à 1 dans le mode magnétoscope. Une porte ET A6 est connectée entre la sortie de l'inverseur I1 et l'entrée R de la bascule B1. La deuxième entrée de la porte ET A6 reçoit le signal de sélection de mode inversé. La porte A2 qui, dans le mode de réalisation de la figure 9, était une porte ET à deux entrées recevant le signal de fenêtre F et le signal STN de sortie de la bascule B1, et qui, dans le mode de réalisation de la figure 11, était également une porte ET à deux entrées recevant le signal F et le signal de sortie ST du comparateur 23, est maintenant une porte ET à trois entrées recevant les signaux F, ST et STN.

Dans le mode de réalisation de la figure 9, le signal à l'entrée R de la bascule B3 résultait de la combinaison de signaux appliqués à une porte ET A3. CEtte porte ET A3 est maintenant remplacée par deux portes ET successives A7 et A8, la sortie de la porte ET A7 étant appliquée à la porte ET A8 par l'intermédiaire d'une porte OU 03. Ainsi, l'entrée R est commandée par les mêmes signaux que ceux de la figure 9 plus le signal de sélection de mode inversé qui est à 1 dans le mode direct et valide cette voie. Dans le schéma de la figure 11, l'entrée R de la bascule B3 recevait des signaux de commande par l'intermédiaire d'une porte ET A4 et de l'inverseur I3. Dans le schéma de la figure 13, l'inverseur I3 est remplacé par une porte ET I'3 qui reçoit à sa première entrée le signal ST inversé et à son autre entrée le signal de sélection de mode. Cette porte est donc validée seulement dans le mode magnétoscope. Ensuite, la porte A8 qui reçoit la sortie de la porte ET I'3 par l'intermédiaire de la porte OU 03 a la même fonction que la porte A4 de la figure 11.

Enfin, la sortie de la bascule B3 qui, dans le mode de réalisation de la figure 11, était appliquée à la porte ET A5 par l'intermédiaire d'un inverseur I2 est maintenant transmise à cette porte A5 par l'intermédiaire d'une porte NON ET I'2 dont l'autre entrée reçoit le signal de sélection de mode.

Le mode de fonctionnement du circuit de la figure 13 est le suivant.

Dans le mode de réception directe, le signal de sélection de mode est à 0. Ainsi, à l'entrée de la bascule B1, la porte 02 actionne l'entrée S de cette bascule seulement en fonction de la porte ET A1 comme dans le cas de la figure 9. La troisième entrée ST de la porte A2 est à 1 quand STN est à 1. Elle n'a donc pas d'action logique particulière. Aux entrées de la bascule B3, la porte ET I'3 est invalidée et la porte ET A7 est validée. On est bien dans le cas du schéma logique de la figure 9. Si l'on considère la figure 10, on notera toutefois qu'il y a une légère différence de fonctionnement dans le mode direct entre les schémas des figures 13 et 9 en ce qui concerne la décharge du condensateur C1 (courbe 10b). En effet, dans le cas de la figure 13, le transistor 52, qui n'existait pas dans le cas de la figure 9, est mis en conduction pour court-circuiter le condensateur C1 pendant la durée du signal RAZ. On voit en examinant les schémas de synchronisation ressortant des courbes de la figure 10 que ceci ne change pas le mode de fonctionnement du circuit. A l'entrée du circuit d'extraction de synchronisation de trame (20-23) la deuxième porte ET A5 qui reçoit un signal de sélection de mode nul sur la deuxième entrée et qui est une porte ET inverseuse fournit en permanence une entrée 1 pendant ce mode direct. La porte ET A5 est donc transparente dans ce mode de fonctionnement.

Dans le mode magnétoscope, les portes A6 et A7 sont invalidées, la porte OU 02 est validée et l'entrée S de la bascule B1 reçoit en permanence un signal 1 ; sa sortie Q fournissant le signal STN est donc constamment à 1 et la porte A2 est validée. On obtient donc bien exactement le fonctionnement du circuit décrit et représenté en relation avec la figure 11.

**Revendications**

1. Procédé de fourniture du signal en dent de scie de balayage vertical d'un téléviseur couplé à un magnétoscope à partir du signal de synchronisation trame fourni par un intégrateur (21–23, C1), caractérisé en ce qu'il comprend les étapes suivantes:
   — interrompre l'action du générateur de dent de scie de trame à partir de l'apparition du signal de synchronisation de trame (ST),
   — à partir de cet instant, ou après un retard prédéterminé à partir de cet instant, mesurer une durée déterminée en utilisant le temps de charge jusqu'à un niveau déterminé du condensateur (C1) dudit intégrateur, et
   — réinitialiser le fonctionnement du générateur de dent de scie de trame à partir de la fin de cette durée déterminée.

2. Procédé selon la revendication 1, caractérisé en ce que l'étape d'interruption comprend les étapes consistant à faire chuter le signal de générateur de dent de scie à bas niveau et à le maintenir à bas niveau.

3. Circuit de fourniture d'un signal en dent de scie de balayage vertical d'un téléviseur associé à un magnétoscope comprenant un intégrateur (21–23, C1) de signal de synchronisation ligne composite fournissant le signal de synchronisation trame (ST), cet intégrateur comprenant deux sources de courant en série (21, 22), le point de connexion de ces deux sources de courant étant connecté à un condensateur (C1) dont l'autre borne est à la masse, la tension sur le condensateur (C1) étant appliquée à une première entrée d'un comparateur (23) dont l'autre entrée reçoit une tension de référence (VR), la sortie de ce comparateur fournissant le signal de synchronisation trame (ST),

caractérisé en ce qu'il comprend un interrupteur commandé (52) connecté aux bornes du condensateur (C1) pour permettre la mise en court-circuit de celui-ci dans un intervalle de temps qui suit l'instant où le comparateur (23) commence à fournir le signal de synchronisation trame (ST).

4. Circuit selon la revendication 3, caractérisé en ce que le signal (ST) est appliqué à une deuxième bascule (B2) qui fournit un signal de courte durée (RAZ) qui est appliqué à l'entrée d'une troisième bascule (B3), fournissant le signal de commande de dent de scie verticale, pour la mettre à haut niveau, la deuxième entrée de la troisième bascule (B3) recevant le signal (ST) inversé, pour être remise à zéro seulement quand le signal (ST) repasse à bas niveau, c'est-à-dire quand le condensateur (C1) s'est rechargé à une tension égale à la tension de référence (VR).

5. Circuit selon la revendication 3, caractérisé en ce que le circuit de génération de dent de scie recevant le signal de sortie de la troisième bascule (B3) comprend un condensateur (C) en série avec une source de courant (31) et en parallèle avec un transitor de court-circuit (30), la borne commune à la source de courant (31) et au condensateur (C) étant reliée par l'intermédiaire d'un circuit adapteur (32) à un comparateur (35) effectuant une comparaison avec une tension de seuil (VS), et en ce que le signal de sortie de la troisième bascule (B3) est appliqué à ladite source de courant (31) et audit comparateur (35) pour les inhiber quand ce signal de sortie est à haut niveau.

6. Circuit selon l'une des revendications 3 à 5, permettant de commander les dents de scie de balayage vertical d'un téléviseur dans le cas où celui-ci reçoit directement des signaux d'antenne, pour fournir dans ce cas un signal de commande associé à l'apparition successive de tops de synchronisation ligne et de largeur égale à l'intervalle entre ces tops de synchronisation, ce circuit comprenant des moyens pour appliquer un signal de sélection de mode à l'état 0 ou 1 selon qu'on est en mode direct ou en mode magnétoscope, ce circuit étant caractérisé en ce qu'il comprend un ensemble de trois bascules dont la première (B1) fournit un signal pendant la présence du signal de synchronisation de trame (ST) à partir de la première apparition d'un top de synchronisation à la fréquence double de la fréquence ligne (H/2), cette première bascule (B1) étant inhibé dans le mode magnétoscope, auquel cas le signal de synchronisation de trame est directement appliqué par un commutateur logique à l'entrée d'un circuit de validation (A2) connecté à la deuxième bascule (B2).

7. Circuit selon la revendication 6, caractérisé en ce que la sortie (STN) de la première bascule (B1) est appliquée à l'entrée de la seconde bascule (B2) par l'intermédiaire d'une porte ET (A2) recevant aussi un signal de fenêtre (F) pour permettre l'application d'un signal sur la deuxième bascule (B2) seulement pendant la durée où il est possible qu'apparaisse normalement un signal (ST).

8. Circuit selon l'une des revendications 6 ou 7, caractérisé en ce que la sortie (STN) de la première bascule (B1) est transmise à l'entrée de la deuxième bascule (B2) par l'intermédiaire d'une porte OU (01) recevant sur sa deuxième entrée un signal (TL) fourni par des circuits logiques du téléviseur à partir du signal à fréquence double (H/2) pour déclencher la deuxième bascule peu après l'instant probable d'apparition du signal de synchronisation de trame (ST), au cas où ce signal n'aurait pas été fourni.

9. Circuit selon l'une quelconque des revendications 6 à 8, caractérisé en ce que la sortie (RAZ) de la seconde bascule (B2) est appliquée aux entrées de remise à zéro d'un ensemble de diviseurs (D1 à D10) connectés séquentiellement et recevant à leur entrée le signal à fréquence double (H/2) pour fournir une succession de signaux logiques.

**Patentansprüche**

1. Verfahren zur Erzeugung eines sägezahnförmigen vertikalen Abtastsignales für ein mit einem Video-Recorder verbundenes Fernsehgerät aus einem Rahmensynchronisationssignal, welches von einem Integrator (21–23, C1) abgegeben wird, gekennzeichnet durch folgende Schritte:
   – Unterbrechen des Betriebes des Sägezahngenerators für das Rahmensynchronisationssignal dann, wenn das Rahmensynchronisationssignal (ST) auftritt,
   – von diesem Zeitpunkt an oder nach einer vorbestimmten Verzögerung nach diesem Zeitpunkt Messen einer bestimmten Zeitspanne unter Verwendung der Ladezeit des Kondensators (C1) des Integrators, welche zum Laden des Kondensators auf einen bestimmten Wert erforderlich ist, und
   – erneutes Starten des Betriebes des Sägezahngenerators für das Rahmensynchronisationssignal am Ende der vorbestimmten Zeitspanne.

2. Verfahren nach Anspruch 1, dadurch gekennzeichnet, daß der Unterbrechungsschritt umfaßt: das Signal von dem Sägezahngenerator ohne Unterbrechung auf einen niedrigen Pegel fallenlassen und es auf diesem niedrigen Pegel halten.

3. Schaltung zur Erzeugung eines sägezahnförmigen vertikalen Abtastsignales für ein mit einem Video-Recorder verbundenes Fernsehgerät, mit einem Integrator (21–23, C1) für das zusammengesetzte Zeilensynchronisationssignal, wobei der Integrator das Rahmensynchronisationssignal (ST) abgibt und wobei der Integrator zwei Stromquellen (21, 22) in Serie umfaßt, deren Verbindungspunkt mit einem Kondensator (C1) verbunden ist, dessen anderer Anschluss an Masse liegt, und wobei weiter die Spannung über dem Kondensator (C1) an einen ersten Eingangsanschluß eines Komparators (23) gegeben wird, dessen anderer Eingangsanschluß an Bezugspotential (VR) liegt und der an seinem Ausgangsanschluß das Rahmensynchronisationssignal (ST) erzeugt, dadurch gekennzeichnet, daß ein gesteuerter Schalter (52) über dem Kondensator (C1) liegt, mit Hilfe dessen der Kondensator innerhalb einer Zeitspanne kurzgeschlossen werden kann, welche auf denjenigen Zeitpunkt folgt, zu dem der Komparator (23) damit beginnt, Rahmensynchronisationssignal (ST) abzugeben.

4. Schalter nach Anspruch 3, dadurch gekennzeichnet, daß das Rahmensynchronisationssignal (ST) einem zweiten Flip-Flop (B2) zugeführt wird, der ein Signal (RAZ) von kurzer Dauer erzeugt, welches an den Eingangsanschluß eines dritten Flip-Flop (B3) gegeben wird, welcher dann das Steuersignal für das sägezahnförmige vertikale Abtastsignal erzeugt, um es auf einen hohen Pegel zu bringen, wobei der zweite Eingangsanschluß des dritten Flip-Flop (B3) das Rahmensynchronisationssignal (ST) invertiert empfängt, um nur dann auf Null zurückgesetzt zu werden, wenn das Rahmensynchronisationssignal (ST) wieder den niedrigen Pegel annimmt, d.h. wenn der Kondensator (C1) sich bis auf eine Spannung entlädt, die der Referenzspannung (VR) gleich ist.

5. Schaltung nach Anspruch 3, dadurch gekennzeichnet, daß die Schaltung zur Erzeugung des Sägezahnes, welche das Ausgangssignal des dritten Flip-Flop (B3) empfängt, einen Kondensator (C) in Serie mit einer Stromquelle (31) und parallel zu einem Kurzschlußtransistor (30) umfaßt, wobei der gemeinsame Anschluss der Stromquelle (31) und des Kondensators (C) über eine Anpassungsschaltung (32) mit einem Komparator (35) verbunden ist, welcher einen Vergleich mit einer Schwellenspannung (VS) durchführt, und daß das Ausgangssignal des dritten Flip-Flop (B3) an die Stromquelle (31) und den Komparator (35) gegeben wird, um diese zu sperren, wenn das Ausgangssignal auf hohem Pegel liegt.

6. Schaltung nach einem der Ansprüche 3 bis 5, welche es erlaubt, das sägezahnförmige vertikale Abtastsignal eines Fernsehgerätes dann zu überwachen, wenn das Fersehgerät Antennensignale direkt empfängt, um in diesem Fall ein Überwachungssignal zu erzeugen, das mit dem aufeinanderfolgenden Auftreten von Spitzen der Synchronisationszeile verbunden ist und dessen Breite den Intervallen zwischen den Synchronisationsspitzen gleich ist, wobei diese Schaltung Mittel zum Abgeben eines Signales zum Auswählen eines Modus 0 oder 1 umfaßt, je nachdem, ob direkter Betrieb oder Video-Recorder-Betrieb vorliegt, und wobei die Schaltung dadurch gekennzeichnet ist, daß sie einen Satz von drei Flip-Flops umfaßt, von denen das erste (B1) für die Dauer des Auftretens des Rahmensynchronisationssignales (ST) von dem ersten Auftreten einer Synchronisationsspitze ab ein Signal mit einer Frequenz abgibt, die doppelt so hoch wie die Zeilenfrequenz (H/2) ist, wobei das erste Flip-Flop (B1) im Video-Recorder-Modus gesperrt ist und in diesem Fall das Rahmensynchronisationssignal direkt mittels eines logischen Schalters (A2) an den Eingang eines Freigabekreises abgegeben wird, welcher mit dem zweiten Flip-Flop (B2) verbunden ist.

7. Schaltung nach Anspruch 6, dadurch gekennzeichnet, daß das Ausgangssignal (STN) des ersten Flip-Flop (B1) über ein UND-Gatter (A2) an den Eingangsanschluß des zweiten Flip-Flop (B2) gegeben wird, wobei das UND-Gatter auch ein Fenstersignal (F) empfängt, um die Abgabe eines Signales an das zweite Flip-Flop (B2) nur während derjenigen Zeitspanne zu erlauben, zu der es normalerweise möglich ist, daß ein Signal (ST) auftritt.

8. Schaltung nach Anspruch 6 oder 7, dadurch gekennzeichnet, daß das Ausgangssignal (STN) des ersten Flip-Flop (B1) am Eingangsanschluß des zweiten Flip-Flop (B2) über ein ODER-Gatter (01) geleitet wird, welches an seinem zweiten Eingangsanschluß ein Signal (TL) empfängt, das von den Logikschaltkreisen des Fernsehgerätes aus dem Signal mit der doppelten Frequenz (H/2) zum Triggern des zweiten Flip-Flop kurz nach dem voraussichtlichen Auftreten des Rahmensynchronisationssignales (ST) erzeugt wird, und zwar dann, wenn dieses Signal nicht abgegeben worden ist.

9. Schaltung nach einem der Ansprüche 6 bis 8, dadurch gekennzeichnet, daß das Ausgangssignal (RAZ) des zweiten Flip-Flop (B2) an den Null-Rücksetzeingang einer Gruppe Dividierer (D1–D10) gegeben wird, wobei diese hintereinander liegen und an ihren Eingangsanschlüssen das Signal mit der doppelten Frequenz (H/2) empfangen, um eine Folge von logischen Signalen abzugeben.

**Claims**

1. A method for providing a vertical deflection saw tooth signal to a TV set associated with a video tape recorder from a frame sychronization signal provided by an integrator (21–23, C1), characterized in this that it comprises the following steps:
   – interrupting the operation of the frame saw tooth generator from the occurrence of the frame synchronization signal (ST),
   – from this time, or after a predetermined delay from this time, measuring a determined time duration by using the charge time up to a determined level of the capacitor (C1) of said integrator, and
   – reinitializing the operation of the frame saw tooth generator from the end of said determined time duration.

2. A method according to claim 1 characterized in this that the interruption step comprises the steps consisting in having the signal from the saw tooth generator drop at a low level and being maintained at low level.

3. A circuit for providing a vertical deflection saw tooth signal to a TV set associated with a video tape recorder comprising an integrator (21–23, C1) of the composite line synchronization signal providing the frame synchronization signal (ST), said integrator comprising two serially connected current sources (21, 22), the junction of said two current sources being connected to a capacitor (C1), the other terminal of which is grounded, the voltage on the capacitor (C1) being applied to a first input of a comparator (23), the other input of which receives a reference voltage (VR), the output of said comparator providing the frame synchronization signal (ST), characterized in this that it comprises a controlled switch (52) connected across the capacitor (C1) for permitting the shorting thereof during a time interval following the time when the comparator (23) begins to provide the frame synchronization signal (ST).

4. A circuit according to claim 3, characterized in this that said frame synchronization signal (ST) is applied to a second flip-flop (B2) which provides a short duration signal (RAZ) applied to the input of a third flip-flop (B3) providing the vertical saw tooth control signal, for setting it at a high level, the second input of the third flip-flop (B3) receiving the inverted signal (ST), for being reset only when the signal (ST) is again switched at a low level, that is, when the capacitor (C1) has been recharged at a voltage equal to the reference voltage (VR).

5. A circuit according to claim 3 characterized in this that the saw tooth generation circuit receiving the output signal from the third flip-flop (B3) comprises a capacitor (C) in series with a current source (31) and in parallel with a shorting transistor (30), the common terminal of the current source (31) and the capacitor (C) being connected through a driving circuit (32) with a comparator (35) providing a comparison with a threshold voltage (VS), and in this that the output signal from the third flip-flop (B3) is applied to said current source (31) and said comparator (35) for inhibiting same when said output signal is at a high level.

6. A circuit according to any of claims 3 to 5 permitting to control the vertical deflection saw teeth of a TV set in case this one directly receives antenna signals, for providing in this case a signal associated to the successive occurrence of line synchronization tops and having a width equal to the time interval between said synchronization tops, this circuit comprising means for applying a mode selection signal at the state 0 or 1 according that the TV set is in a direct mode or in a video tape recorder mode, this circuit being characterized in this that it comprises a set of three flip-flops, the first of which (B1) provides a signal during the presence of the frame synchronization signal (ST) from the first occurrence of a synchronization top at a frequency equal to twice the line frequency (H/2), said first flip-flop (B1) being inhibited in the video tape recorder mode, in which case the frame synchronization signal is directly applied through a logic switch to the input of an enabling circuit (A2) connected to the second flip-flop (B2).

7. A circuit according to claim 6 characterized in this that the output (STN) of the first flip-flop (B1) is applied to the input of the second flip-flop (B2) through an AND gate (A2) also receiving a window signal (F) for permitting a signal to be applied on the second flip-flop (B2) only during the duration where it is normally possible that a signal (ST) occurs.

8. A circuit according to claim 6 or 7, characterized in this that the output (STN) of the first flip-flop (B1) is transmitted to the input of the second flip-flop (B2) through an OR gate (01) receiving on its second input a signal (TL) provided by logic circuits of the TV set from a double frequency signal (H/2) for triggering the second flip-flop shortly after the probable time of occurrence of the frame synchronization signal (ST), in case this signal has not been provided.

9. A circuit according to any of claims 6 to 8, characterized in this that the output (RAZ) of the second flip-flop (B2) is applied to the resetting inputs of a set of dividers (D1 to D10) sequentially connected and receiving on their input the double frequency signal (H/2) for providing a succession of logic signals.

# FIG_1-A

# FIG_1-B

# FIG_1-C

# FIG_1-D

−VR

# FIG_1-E

# FIG_2

# FIG_3

FIG_4-A

FIG_4-B

FIG_4-C

FIG_5

FIG_6-A

FIG_6-B

FIG_7

FIG_8

FIG_9

EP 0 230 828 B1

FIG_10-a

FIG_10-b

FIG_10-c

FIG_10-d

FIG_10-e

FIG_10-f

FIG_10-g

FIG_10-h

FIG_10-i

FIG_10-j

FIG_10-k

FIG_11

SEPARATEUR
SYNCHRO
LIGNE

EP 0 230 828 B1

FIG_12-a

FIG_12-b

FIG_12-c

FIG_12-d

FIG_12-e

FIG_12-f

FIG_12-g

FIG_12-h

FIG_13

EP 0 230 828 B1